# EUROPEAN PATENT APPLICATION

(11) **EP 2 071 617 A2**
(43) Date of publication of application: **17.06.2009**
(21) Application number: 08020463.9
(22) Date of filing: 25.11.2008
(51) Int. Cl.: H01L 21/67

(54) **Overhead buffer and transfer method of the same**

(30) Priority: 10.12.2007 JP 2007318332
(71) Applicant: Murata Machinery, Ltd., Minami-ku Kyoto-shi Kyoto 601-8326 (JP)
(72) Inventor: Kato, Susumu, Inuyama-shi Aichi 484-8502 (JP)
(74) Representative: Schoppe, Fritz

(57) **Abstract**

First support members (6) are attached to a ceiling (4) at a fixed pitch, so that raceways (8) each including a horizontal opening (32) in a lower portion are supported by the first support members (6), and second support members (12) are attached to the raceways (8) to install a shelf for placing an article, at lower ends thereof.

## Description

### BACKGROUND OF THE INVENTION

### Field of the Invention

The present invention relates to improvement of an overhead buffer used in combination with an overhead traveling vehicle or the like.

### Description of the Related Art

Patent Document 1: Japanese Laid-Open Patent Publication No. 2006-324469 discloses that an overhead buffer is provided on one side of a traveling rail of an overhead traveling vehicle to temporarily place an article conveyed by the overhead traveling vehicle. By providing the overhead buffer, the article can be temporarily placed in the adjacent overhead buffer when an objective load port is filled, and the article can be carried in when the load port becomes available. Moreover, when the overhead traveling vehicle that conveys an article from a load port in a pickup position to a conveyance destination cannot be assigned, the article is conveyed to an overhead buffer in the vicinity of the pickup position, so that the load port in the pickup position can be made available. As understood from the above description, the overhead buffer often corresponds to the load port of a processing device, and more overhead buffers are often provided, or the overhead buffer is often transferred in accordance with the installation, transfer or the like of the processing device. The load port is a carrying-in and out location of an article provided in the processing device. Hereinafter, the overhead buffer may also be simply referred to as a buffer.

In Patent Document 1, one of the right and left sides of the buffer is supported by the traveling rail of the overhead traveling vehicle, and the other is hung from a ceiling by columns. The ceiling of a clean room tends to be higher, and hanging the buffer from the ceiling by the columns such as hanging bolts involves high-place work during moving the buffer. This makes the transfer of the buffer difficult.

### SUMMARY OF THE INVENTION

An object of the present invention is to make the transfer of an overhead buffer easier.

An overhead buffer of the present invention is an overhead buffer supporting a shelf allowing an article to be freely passed and received between an overhead traveling vehicle and itself, by a support member extending in a vertical direction, characterized in that:
the support member is made of a first support member that is attached to a ceiling, and supports a first raceway having an opening along a horizontal direction in a lower portion thereof, and a second support member that is attached to the raceway slidably in the horizontal direction, and supports the shelf.

According to the present invention, there is also provided a method for transferring an overhead buffer that supports a shelf allowing an article to be freely passed and received between an overhead traveling vehicle and itself, by a support member extending in a vertical direction, characterized by including the steps of:
fixing a first support member to a ceiling;
attaching a first raceway having an opening along a horizontal direction in a lower portion thereof to the first support member;
attaching a second support member to the raceway; and
attaching the shelf to the second support member to thereby install the overhead buffer; and further,
sliding the second support member in the horizontal direction along the raceway to thereby transfer the overhead buffer.

Preferably, the shelf is made of a second raceway attached to the second support member and having an opening along the horizontal direction, and a placement member for the article supported slidably in the horizontal direction by the second raceway.
More preferably, the second support member is made of support members on both ends of the shelf, and a support member in a middle portion of the shelf, the support member in the middle portion of the shelf is horizontally slidable along the first raceway and the second raceway, and attachment members each including two pieces forming an L shape and a joining portion that joins the two pieces are arranged on both front and rear sides of the second support member along the opening of the first raceway, and one of the L-shaped two pieces is attached to the raceway, and the other piece is attached to the second support member.

In the present invention, by horizontally moving the second support member along the raceway, the overhead buffer can be transferred easily. Moreover, since the first support member is attached to the ceiling, and the second support member is attached to the raceway, a length of the shelf of the buffer is not limited by the attachment pitch to the ceiling.

By making up the shelf by the second raceway attached to the second support member, and the placement member for the article supported slidably in the horizontal direction by the second raceway, a placement position can be easily changed.
Furthermore, once the one piece of the L-shaped attachment member is attached to the second support member and the other piece is attached to the first raceway to join the two pieces of the L shape, the second support member can be solidly attached to the first raceway. Therefore, no beam for mutually joining the second support members is required. When the second support member supporting the middle portion of the shelf is slid along the first and second raceways, the arrangement of the placement member on the shelf can be changed easily.

### BRIEF DESCRIPTION OF THE DRAWINGS

Fig. 1 is a side view of essential parts of an overhead buffer of an embodiment.
Fig. 2 is a front view of the overhead buffer of the embodiment.
Fig. 3 is a front view showing the overhead buffer and an overhead traveling vehicle.
Fig. 4 is a plane view of a lower support member and attachment members according to the embodiment.
Fig. 5 is a side view showing a state where the lower support member is attached to an upper raceway according to the embodiment.
Fig. 6 is a view showing attachment of a sheet to the lower raceway according to the embodiment.
Fig. 7 is a side view of essential parts of the overhead buffer in which a position of the lower support member is changed from that of Fig. 1.

### DESCRIPTION OF REFERENCE NUMERALS

- 2: overhead buffer
- 4: ceiling
- 6: hanging bolt
- 8: upper raceway
- 10: buffer unit
- 12: lower support member
- 14: attachment member
- 15: reinforcement plate
- 16: lower raceway
- 18: sheet
- 20: rail
- 22: hanging bolt
- 24: overhead traveling vehicle
- 26: FOUP
- 27: θ drive
- 28: hoist
- 29: chuck
- 30: lateral drive

- 31: safety cover
- 32: opening
- 34: nut
- 36, 37: plate
- 38,39: opening
- 40, 41: bolt
- 42: nut plate
- 45: brace
- 50: bolt
- g1, g2: gap

### DETAILED DESCRIPTION OF PREFERRED EMBODIMENTS

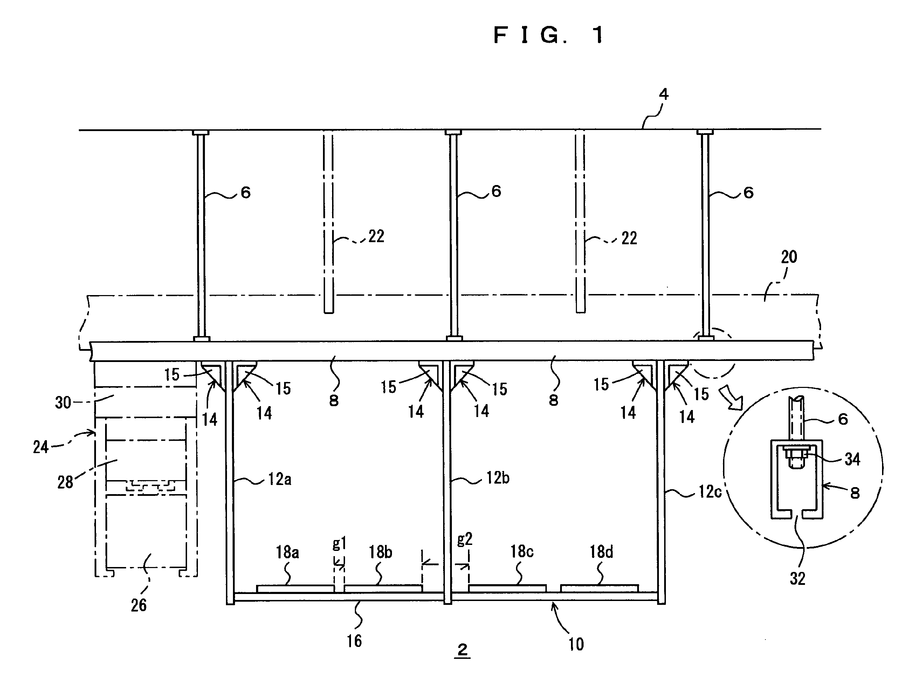

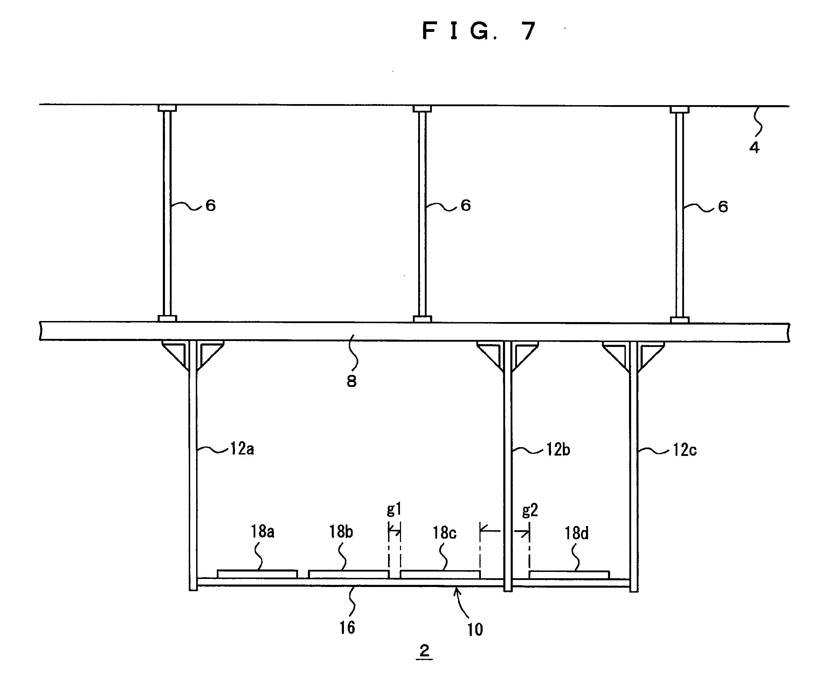

In Figs. 1 to 7, an overhead buffer 2 of one embodiment is shown. Reference numeral 4 denotes a ceiling of a clean room or the like, to which hanging bolts 6 are attached at a fixed pitch. Reference numeral 8 denotes an upper raceway, and its structure is shown as an enlarged view in a lower right portion of Fig. 1. In a bottom portion of the raceway 8, there is a horizontal opening 32 along a longitudinal direction of the raceway 8 to attach a lower end of each of the hanging bolts 6 to an upper surface of the raceway 8 by a nut 34 or the like. The raceway 8 has no opening along the longitudinal direction in the upper surface, and thus, through-holes are provided in the upper surface of the raceway 8 in appropriate positions to fix the hanging bolts 6 by the nuts 34.

A buffer unit 10 is provided under the raceway 8. Reference numeral 12 denotes a lower support member, and reference numeral 14 denotes an attachment member for attaching both front and rear sides of the lower support member 12 to the raceway 8 using the opening 32, and reference numeral 15 denotes a triangle-shaped reinforcement plate connecting both pieces of an L shape of the attachment member 14. Reference numeral 16 denotes a lower raceway to which a plurality of sheets 18 on a tray for placing an article such as an FOUP are attached. Appropriate bars may be used in place of the lower raceways 16, and as the lower support members 12, while three support members 12a to 12c are used here, two support members that support both ends of the buffer unit 10 may be used. With a gap between the sheets 18, in the case where the lower support member 12b interposes between them, the gap is set to a relatively large value g2, and in the case where the lower support member 12b does not interpose, it is set to a relatively small value g1. The plurality of buffer units 10 are attached in appropriate positions along the raceways 8.

The overhead buffer 2 passes and receives an article such as an FOUP 26 between an overhead traveling vehicle system and itself. A rail 20 is supported from the ceiling 4 by hanging bolts 22 to run an overhead traveling vehicle 24. The overhead traveling vehicle 24 moves up and down the FOUP 26 by a hoist 28, and advances and retracts the hoist 28 and the FOUP 26 by a lateral drive 30 horizontally and perpendicularly to the rail 20 to pass and receive the FOUP 26 between the sheet 18 and itself.

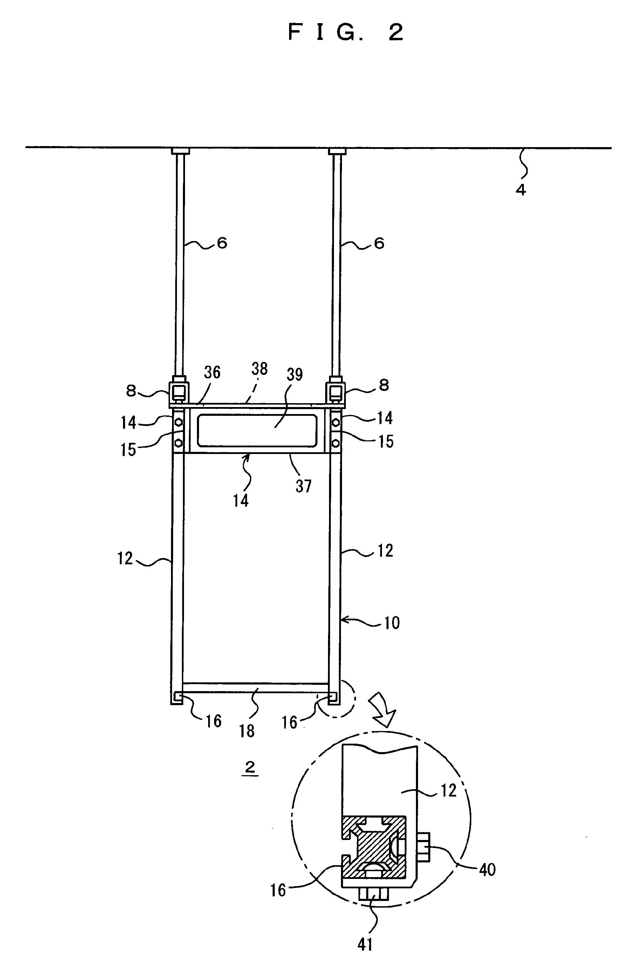

Fig. 2 shows a front view of the overhead buffer 2, and a pair of right and left hanging bolts 6, 6 extends from the ceiling 4 downward in a vertical direction to support the upper raceways 8 whose longitudinal direction is horizontal. The pair of right and left vertical lower support members 12 is attached to the upper raceways 8 through the attachment members 14, and the sheets 18 are attached to the bottom portions of the lower support members 12 through the lower raceways 16 whose longitudinal direction is horizontal.

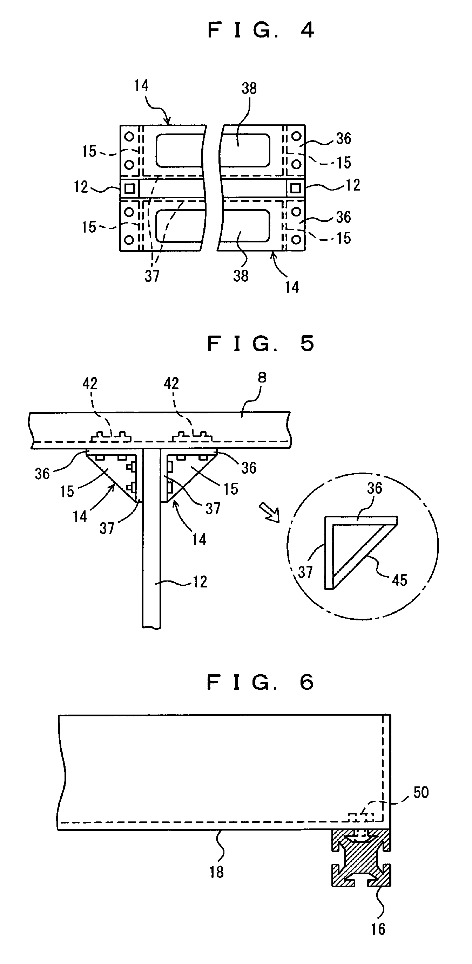

Each of the attachment members 14 is made of metal, joins the right and left lower support members 12, 12, and includes plates 36, 37 forming two pieces of the L shape. In the plates 36, 37, openings 38, 39 are provided for reducing weight.
Further, the plates 36, 37 are joined and reinforced by the reinforcement plate 15. As shown in Figs. 4, 5, the attachment members 14,14 are attached to the front and rear sides of each of the lower support members 12, that is, in the longitudinal direction of the raceway 8, respectively, and the plates 36 are attached to bottom surfaces of the raceways 8 by bolts and nut plates 42 and the like, and the plates 37 are attached to the lower support members 12 by bolts. The nut plate 42 is a plate provided with a nut, and is slidable inside the raceway 8.

The attachment members 14 allow the right and left lower support members 12 to be joined to each other, and the lower support members 12 are prevented from being swung back and forth, that is, along the longitudinal direction of the raceways 8. Thus, no brace is required in an intermediate position of the raceway 8 and the raceway 16.
As shown in a lower right portion of Fig. 5, terminal portions of the plates 36, 37 may be joined by a brace 45 or the like in place of the reinforcement plate 15.

As shown in a lower portion of Fig. 2, the lower raceway 16 has four openings, for example, along the longitudinal direction, and utilizing these openings, is attached to the lower support member 12 by bolts 40, 41 and the like. Then, the sheet 18 is fixed to the lower raceway 16, utilizing a bolt 50, and the upper opening of the lower raceway 16 or the like, as shown in Fig. 6.

Installation of the overhead buffer 2 of the embodiment is described. The hanging bolts 6 can be freely attached to the ceiling 4 only at the predetermined pitch. At this pitch, the hanging bolts 6 are attached in two right and left rows, and the upper raceways 8 are fixed to the lower ends. For example, the plates 36 of the attachment members 14 are temporarily attached to the upper raceways 8, and the lower support members 12 are firmly fixed to the plates 37. Subsequently, the lower raceways 16 are attached to the lower support members 12, and the sheets 18 are attached. In this process, since the lower support members 12 are slidable along the upper raceways 8, the positions can be adjusted. When the adjustment of the positions of the respective parts is finished, the lower support members 12 are fixed to the upper raceways 8, the lower raceways 16 are fixed to the lower support members 12, and the sheets 18 are fixed to the lower raceways 16. The buffer unit 10 may be assembled in advance, and then, may be attached to the upper raceways 8.

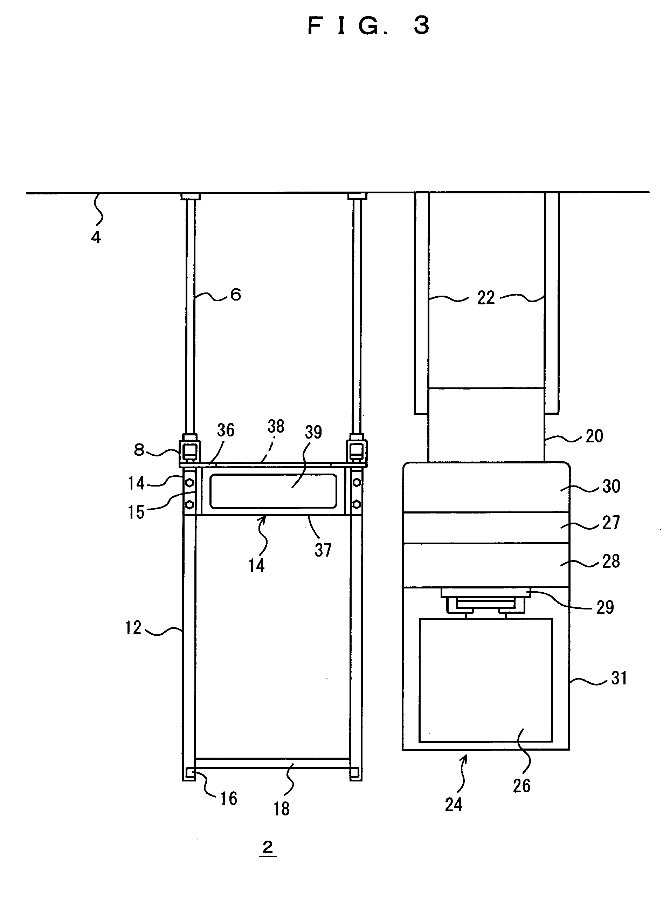

Fig. 3 shows a relation between the overhead traveling vehicle 24 and the overhead buffer 2. The overhead traveling vehicle 24 includes a traveling drive part and a power receiving part inside the rail 20, and travels along the rail 20, and receives power from the rail 20 side by non-contact power feeding or the like. A θ drive 27 to the FOUP 26 are moved laterally by the lateral drive 30, and the orientation of the hoist 28 and the FOUP 26 is turned in a horizontal plane by the θ drive 27. The hoist 28 moves up and down the FOUP 26, and chucks and releases an upper flange of the FOUP 26 by a chuck 29. Moreover, a safety cover 31 prevents the FOUP 26 from falling. With the above-described constitution, the overhead traveling vehicle 24 can freely pass and receive the FOUP 26 between the sheets 18, a load port not shown and the like, and itself.

With the movement of the processing device or the like in the clean room, there may arise a need for transferring the buffer unit 10. This is because the buffer unit 10 is often provided in a position opposed to the processing device, or the like. When the buffer unit 10 is transferred, the attachment of the attachment members 14 to the upper raceways 8 is loosened, the entire buffer unit 10 can be slid along the raceways 8. This allows the buffer unit 10 to be transferred extremely easily. Moreover, with the exchange of the processing device, there may arise a need for adjusting the positions of the individual sheets 18a to 18d. In this case, the lower support members 12a, 12c on both ends of the buffer unit 10 are not moved, but a position of the lower support members 12b in the middle is moved. The fixation of the lower support members 12b in the middle to the raceways 8, 16 is made weak to slide them to predetermined positions. In addition, the sheet 18c or the like is moved along the raceways 16. This can change the gap between the sheets 18b, 18c, and the gap between the sheets 18c, 18d. It is because no braces joining the lower support members 12a to 12c in intermediate positions in a height direction and so on are present that the lower support members 12b can be slid alone.

According to the embodiment, the following effects can be obtained.
(1) The setting position, length or the like of the buffer unit 10, are not limited by the attachment pitch of the hanging bolts 6 to the ceiling 4.
(2) The buffer unit 10 can be moved easily by being slid along the upper raceways 8.
(3) The movement of the lower support members 12b in the middle can change the arrangement of the sheets 18a to 18d.
(4) The lower support members 12 can be joined to each other by the attachment members 14, and can be attached to the upper raceways 8 solidly.

While the buffer unit 10 of the embodiment is arranged for example, on the side of, and parallel to the rail 20 of the overhead traveling vehicle 24, the buffer unit 10 may be arranged under the rail 20.

## Claims

1. An overhead buffer (2) comprising a shelf allowing an article to be passed and received between an overhead traveling vehicle (24) and the shelf, and a support member (6, 12) extending in a vertical direction and supporting the shelf,
**characterized in that:**
said support member (6, 12) is made of a first support member (6) that is attached to a ceiling (4), and supports a first raceway (8) having an opening (32) along a horizontal direction in a lower portion thereof, and a second support member (12) that is attached to said raceway (8) slidably in the horizontal direction, and supports said shelf.

2. The overhead buffer (2) according to claim 1, **characterized in that** said shelf is made of a second raceway (16) attached to the second support member (12) and having an opening along the horizontal direction, and a placement member (18) for the article supported slidably in the horizontal direction by said second raceway (16).

3. The overhead buffer (2) according to claim 2, **characterized in that:**
said second support member (12) is made of support members (12a, 12c) on both ends of the shelf, and a support member (12b) in a middle portion of the shelf;
the support member (12b) in the middle portion of the shelf is horizontally slidable along said first raceway (8) and said second raceway (16); and
attachment members (14) each including two pieces (36, 37) forming an L shape and a joining portion (15) that joins said two pieces (36, 37) are arranged on both front and rear sides of the second support member (12) along the opening (32) of said first raceway (8), and one (36) of said L-shaped two pieces (36, 37) is attached to the raceway (8), and the other piece (37) is attached to the second support member (12).

4. A method for transferring an overhead buffer (2) comprising a shelf allowing an article to be passed and received between an overhead traveling vehicle (24) and the shelf and a support member (6, 12) extending in a vertical direction and supporting the shelf, **characterized by** comprising the steps of:
fixing a first support member (6) to a ceiling (4);
attaching a first raceway (8) having an opening (32) along a horizontal direction in a lower portion thereof to said first support member (6);
attaching a second support member (12) to said raceway (8);
attaching the shelf to said second support member (12) to thereby install the overhead buffer (2); and
sliding said second support member (12) in the horizontal direction along said raceway (8) to thereby transfer the overhead buffer (2).
